# EUROPEAN PATENT APPLICATION

(11) **EP 3 065 517 A1**
(43) Date of publication of application: **07.09.2016**
(21) Application number: 16158377.8
(22) Date of filing: 03.03.2016
(51) Int. Cl.: H05K 5/00, F16K 31/12, H05K 7/02

(54) **CIRCUIT BOARD CONNECTING STRUCTURE**

(30) Priority: 03.03.2015 JP 2015041039
(71) Applicant: Azbil Corporation, Chiyoda-ku Tokyo 100-6419 (JP)
(72) Inventor: MURATA, Kouichiro, Tokyo, Tokyo 100-6419 (JP)
(74) Representative: Lavoix

(57) **Abstract**

An electrode structural unit is fitted into, and held removably in, a portion of an inner peripheral wall of a case. The electrode structural unit has insulating material as a substrate, and is provided with a plurality of through-electrodes through that pass through the insulating material in the vertical direction. Bottom face electrode surfaces that are exposed on the bottom face of the electrode structural unit are brought into contact with electrodes for connecting to the various types of electrode components within the case. The top face electrode surfaces that are exposed on the top face of the electrode structural unit are caused to contact the electrodes that are formed on the circuit board.

## Description

### Field of Technology

The present invention relates to a circuit board connecting structure for connecting between a circuit board and various types of electronic components contained within a case.

### Background

Conventionally, positioners have been provided in control valves, where the valve opening of the control valve is adjusted by the positioner. This positioner is provided with, for example, a calculating portion for calculating a deviation between a valve opening set point, which is sent from a higher-level device, and an actual opening value, which is fed back from a regulator valve, and for generating, as a control output, an electric signal reflecting this deviation; an electro-pneumatic converting portion for converting the generated control output into a nozzle back pressure; a pilot relay for amplifying, and outputting, as an output air pressure, to a regulator valve operating device, the nozzle back pressure that has been converted by the electro-pneumatic converting portion.

Such a positioner is provided with electrical components such as angle sensors, pressure sensors, and the like, which are contained in a case together with electrical components such as the electro-pneumatic converting portion, where these various types of electrical components are connected to circuit boards within the case.

Typically, for the connections between these various types of electrical components and circuit boards within the case, harnesses (cables + connectors) or connecting pins are provided on the circuit board or sensor side, and these harnesses or connecting pins are connected to the connectors on the other side (referencing, for example, Japanese Unexamined Patent Application Publication 2014-199842).

Note that in such a positioner, the connections between the various types of electrical components and circuit boards within the case must allow the circuit boards to be installed and removed easily at the time of manufacturing and maintenance inspections. Moreover, positioners are always required to be robust to noise, to be small, and to have explosive-proof structures.

Also, the typical system wherein harnesses or connecting pins are used for connecting various types of electrical components and circuit boards within a case has problems such as the following:
(1) The harness is unstable in regards to noise that propagates from the case (reducing the robustness to noise).
   Sometimes there can be negative effects from noise due to capacitive coupling between the case and the signal lines.
   At this time, because the distance from the harness to the case will not be constant, there is a tendency to be affected by normal mode noises.
(2) The procedure for attaching the harness is complex (reducing maintainability and manufacturability).
   When the harness is long it is difficult to enclose in a container, and if short, it is difficult to secure the space when making a connection.
   When attaching, there is the possibility that the harness or a connecting pin will break.
(3) Miniaturization is difficult due to the provision of the harness or connecting pin (making miniaturization difficult).
   For the harness, when considering the location of the container, innovations are necessary to isolate the circuit board, in an anti-explosive structure.
   The connection requires space, necessitating some degree of size.

The present invention was created in order to solve problems such as this, and the object thereof is to provide a circuit board connecting structure that is resistant to the effects of noise, wherein the connection is easy, having superior maintainability and manufacturability, and wherein there is little possibility of an open circuit or broken circuit, and wherein miniaturization is possible.

### Summary

In order to achieve such an object, the present invention is a circuit board connecting structure for connecting between a circuit board and various types of electrical components contained in a case, wherein the case includes an inner peripheral wall surrounding a space wherein the various types of electrical components are contained; and an electrode structural unit that has, as a substrate, an insulating material that is fitted into, and held removably in, a portion of the inner peripheral wall. The electrode structural unit includes a plurality of through-electrodes provided extending through the inner peripheral wall of the case in a direction that is perpendicular to the circumferential direction thereof; the through-electrodes have end faces on one side exposed on one side face of the insulating material as first electrode surfaces and have end faces on the other side exposed on the other side face of the insulating material as second electrode surfaces; the circuit board is attached to the case so that the electrodes formed on the circuit board are in contact with the first electrode surfaces of the through-electrodes; and the various types of electrical components are contained within the case so that the electrodes for connecting the various types of electrical components contacted the second electrode surfaces of the through-electrodes.

In the present invention, the various types of electrical components and a circuit board can be connected through an electrode structural unit that is inserted removably into, and held in, a portion of an inner peripheral wall of a case. This electrode structural unit has insulating material as a substrate, and has a plurality of through-electrodes in the direction that is perpendicular to the circumferential direction of the inner peripheral wall of the case (that is, in the vertical direction of the case), where an end face on one end side (the end face on the top side) is exposed at the face on one end side of the insulating material (that is, the top face) as a first electrode surface (a top face electrode surface), and an end face on the other side (a bottom side end face) is exposed at a face on the other side of the insulating material (that is, the bottom face), as a second electrode surface (a bottom face electrode surface). Within the case, electrodes that are formed on a circuit board contact the first electrode surface (the top face electrode surface) that is exposed at the face on one side of the electrode structural unit (the top face), and the electrodes for connecting the various types of electrical components contact the second electrode surface (the bottom face electrode surface) that is exposed on the other side face (the bottom face) of the electrode structural unit.

In this way, in the present invention, connections between the various types of electrical components and the circuit board are made by electrodes contacting a first electrode surface and a second electrode surface that are exposed on one side surface and the other side surface of an electrode structural unit, enabling elimination of the harness and the connecting pins, causing the capacitive coupling between the signal line and the case to be constant, reducing the susceptibility to noise. Moreover, the connection is easy, the maintainability and manufacturability is good, and the possibility of an open circuit and of breakage is low. Moreover, because the physical volume is reduced, the case can be miniaturized.

In the present invention, when the case is an explosive-proof case, there is no possibility of the harness contacting the substrate, thus enabling the structure to be simplified, making connection easy.

In the present invention, an electrode structural unit provided with a plurality of through-electrodes is attached removably to a portion of an inner peripheral wall of a case, and the connections between various types of electrical components and circuit boards is made through the contact of electrodes to first electrode surfaces and second electrode surfaces that are exposed on one side surface and the other side surface of this electrode structural unit, and thus the capacitive coupling between the signal lines and the case will be constant, making it possible to reduce susceptibility to the effects of noise. Moreover, this enables easy connectability, superior maintainability and manufacturability, a low possibility of open circuits or breakage, and the ability to achieve miniaturization.

### Brief Descriptions of the Drawings

FIGs. 1(a) and (b) are diagrams illustrating critical portions of one embodiment of a circuit board connecting structure according to the present invention.
FIG. 2(a) is a plan view and FIG. 2(b) a front view of an electrode structural unit used in the circuit board connecting structure.
FIGs. 3(a) and (b) are diagrams illustrating the state of the circuit board prior to attachment to the top face of the case.
FIG. 4 is a diagram wherein the circuit board is viewed from the back face side.

### Detailed Description

Examples according to the present disclosure will be explained below in detail, based on the drawings.

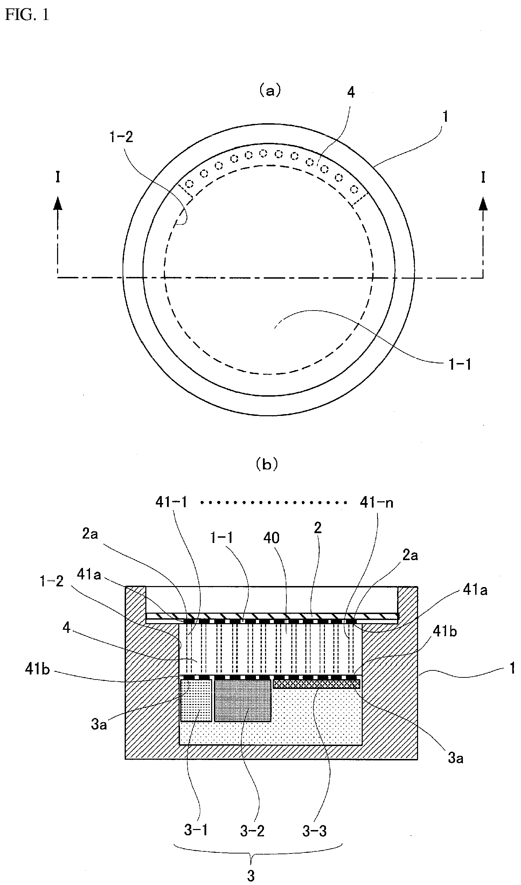

FIG. 1 is a diagram illustrating critical portions of an example of a circuit board connecting structure according to the present invention, wherein FIG. 1(a) is a plan view and FIG. 1 (b) is a cross-sectional view along the section I-I in FIG. 1 (a).

In FIG. 1, 1 is a case, 2 is a circuit board, 3 is various types of electronic components contained within the case 1, and 4 is the electrode structural unit. In the present invention, the case 1 is the case of the positioner (and anti-explosive case), where various types of electronic components 3 such as an electro-pneumatic converting portion 3-1, an angle sensor 3-2, a pressure sensor substrate 3-3, and the like, are contained within the case 1.

Moreover, although not illustrated, integrated circuits, such as a CPU (Central Processing Unit), a RAM (Random Access Memory), a ROM (Read Only Memory), and the like, are mounted on the circuit board 2, to structure the various types of circuits that are required for the functions of the positioner, such as an electric power supplying circuit portion, a calculating portion, and the like.

This circuit board 2 is circular, and is attached to a top face of the case 1 so as to block an opening portion 1-1 of the case 1. That is, it is attached to the top face of the case 1 so as to close the opening portion 1-1 of the case 1 that is a container opening, from the outside of the various types of electrical components 3.

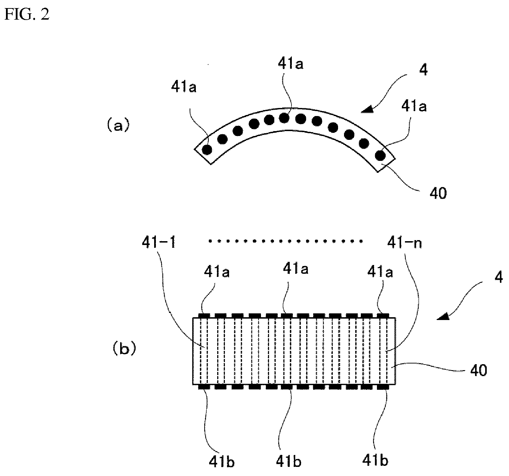

An electrode structural unit 4 that has an insulating material (resin) as a substrate is inserted into and held in a portion of the inner peripheral wall 1-2 that surrounds the space that contains the electrical components 3 of the case 1. A plan view of the electrode structural unit 4 is shown in FIG. 2(a), and a front view of the electrode structural unit 4 is shown in FIG. 2(b).

In the electrode structural unit 4, an arc -shaped member that follows the curve of the wall surface of the inner peripheral wall 1-2 of the case 1 is used as a substrate 40, and a plurality of through-electrodes 41-1 through 41-n penetrate through this substrate 40 in a direction that is perpendicular to the circumferential direction of the inner peripheral wall 1-2 (that is, in the vertical direction).

The through-electrodes 41-1 through 41-n are embedded in a substrate (insulating material) 40, with the end faces on one side thereof (the top side end faces) exposed, as first electrode surfaces (top face electrode surfaces) 41 a on the one side face (the top face) of the substrate 40, and the end faces on the other side thereof (the bottom side end faces) exposed, as second electrode surfaces (bottom face electrode surfaces) 41 b on the other side face (the bottom face) of the substrate 40.

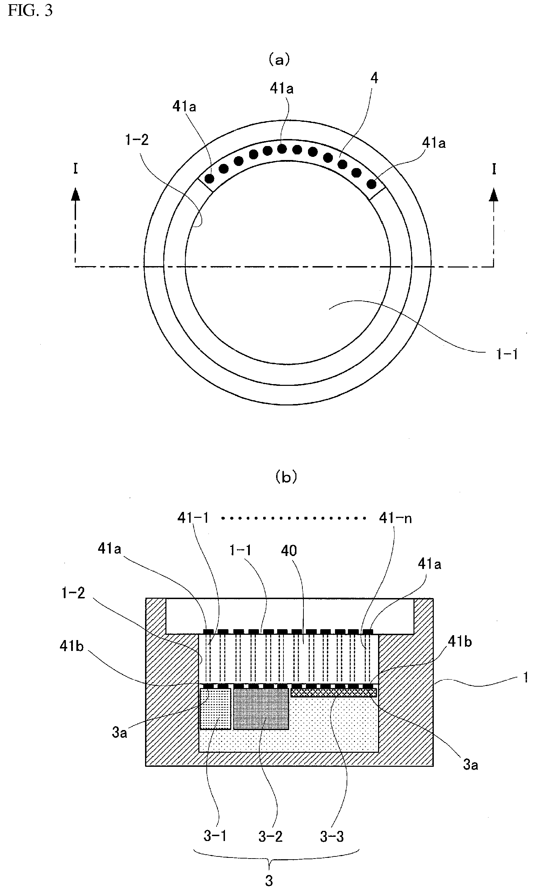

FIG. 3 shows a state of the circuit board connecting structure before attaching the circuit board 2 to the top face of the case 1 of the circuit board connecting structure shown in FIG. 1. In this state, the bottom face electrode surfaces 41 b, which are exposed at the bottom face of the electrode structural unit 4, contact the electrodes 3a for connecting to the various types of electrical components 3 within the case 1.

In this example, various types of electrical components 3 are secured within the case 1 so as to not move, and through fitting (pressing) the electrode structural unit 4 into a portion of the inner peripheral wall 1-2 of the case 1, the bottom face electrode surfaces 41 b, which are exposed at the bottom face of the electrode structural unit 4, are caused to contact the electrodes 3a for connecting the various types of electrical components 3 within the case 1, so as to maintain the state of contact between these electrodes 3a and the bottom face electrode surfaces 41 b. Note that the flat shapes of the various types of electrical components 3 are omitted in FIG. 3(a).

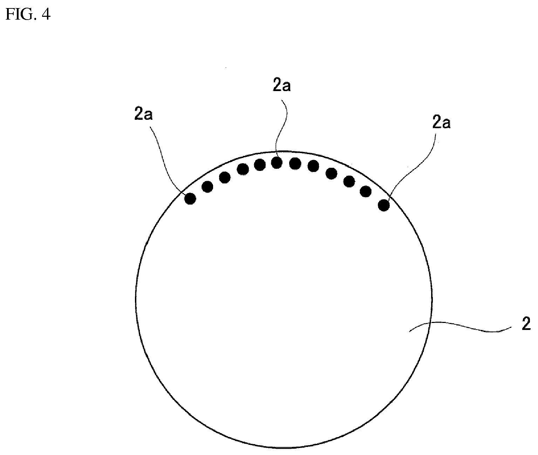

FIG. 4 shows a diagram of the circuit board 2, in FIG. 1, when viewed from the back face side. Various types of circuits can be structured on the substrate in the circuit board 2, and electrodes 2a are formed for connecting to these various types of circuits that are structured. In FIG. 1, the circuit board 2 is attached to the top face of the case 1 with the face wherein the electrodes 2a are formed facing downward. In this state, the top face electrode circuits 41 a that are exposed on the top face of the electrode structural unit 4 contact the electrodes 2a that are formed on the circuit board 2, to maintain the state of contact between the electrodes 2a and the top face electrodes 41 a.

In this way, in this example, the connections between various types of electrical components 3 and the circuit board 2 are formed through contacting electrodes 2a and electrodes 3a to the top face electrode surfaces 41 a and the bottom face electrode surfaces 41 b that are exposed on the top face and bottom face of the electrode structural unit 4, thus making it possible to eliminate the harness and the connecting pins, while causing the capacitive coupling between the signal lines in the case 1 to be constant, thereby reducing the susceptibility to noise. Moreover, the connection is easy, the maintainability and manufacturability is good, and the possibility of an open circuit and of breakage is low. Moreover, because the physical volume is reduced, the case 1 can be miniaturized.

Note that while in the present embodiment the case 1 is a case for a positioner, it need not necessarily be a case for a positioner. Moreover, the various types of electrical components 3 are not necessarily limited to being an electro-pneumatic converting portion 3-1, an angle sensor 3-2, a pressure sensor substrate, 3-3, and the like.

While the present disclosure has been explained above in reference to an example, the present disclosure is not limited to the example set forth above. The structures and details in the present disclosure may be varied in a variety of ways, as can be understood by one skilled in the art, within the scope of technology in the present disclosure.

### List of Reference Signs

- 1:: Case
- 1-1:: Opening Portion (Container Opening)
- 1-2:: Inner Peripheral Wall
- 2:: Circuit Board
- 2a:: Electrode
- 3:: Various Types of Electrical Components
- 3a:: Electrode
- 3-1:: Electro-pneumatic Converting Portion
- 3-2:: Angle Sensor
- 3:: Pressure Sensor Substrate
- 4:: Electrode Structural Unit
- 40:: Substrate (Insulating Material)
- 41-1: through 41-n: Through-Electrodes
- 41 a:: First Electrode Surface (Top Face Electrode Surface)
- 41 b:: Second Electrode Surface (Bottom Face Electrode Surface)

## Claims

1. A circuit board connecting structure for connecting between a circuit board (2) and various types of electrical components (3) comprising:
a case (1), comprising:
an inner peripheral wall (1-2) surrounding a space wherein the various types of electrical components (3) are contained; and
an electrode structural unit (4) that comprises, as a substrate, an insulating material that is fitted into, and held removably in, a portion of the inner peripheral wall; wherein the electrode structural unit (4) comprises:
a plurality of through-electrodes (41-1 through 41-n) provided extending through the inner peripheral wall of the case (1) in a direction that is perpendicular to the circumferential direction thereof;
wherein the through-electrodes (41-1 through 41-n) comprise end faces on one side exposed on one side face of the insulating material as first electrode surfaces and have end faces on the other side exposed on
the other side face of the insulating material as second electrode surfaces;
wherein the circuit board (2) is attached to the case (1) so that the electrodes formed on the circuit board (2) are in contact with the first electrode surfaces of the through-electrodes (41-1 through 41-n); and
wherein the various types of electrical components (3) are contained within the case (1) so that the electrodes for connecting the various types of electrical components (3) contacted the second electrode surfaces of the through-electrodes (41-1 through 41-n).

2. A circuit board connecting structure as set forth in Claim 1, wherein the case (1) is an explosion proof case.
